# EUROPEAN PATENT APPLICATION

(11) **EP 2 228 168 A1**
(43) Date of publication of application: **15.09.2010**
(21) Application number: 08866587.2
(22) Date of filing: 09.12.2008
(51) Int. Cl.: B23K 35/26, C22C 12/00, H01L 21/52

(54) **BONDING MATERIAL, ELECTRONIC COMPONENT, AND BONDED STRUCTURE**

(30) Priority: 27.12.2007 JP 2007336246
(71) Applicant: Panasonic Corporation, Kadoma-shi Osaka 571-8501 (JP)
(72) Inventor: Fuusawa ,Akio c/o Panasonic Corporation, Osaka 540-6207 (JP); Sakaguchi,Shigeki C/o Panasonic Corporation, Osaka 540-6207 (JP); Suetsugu,Kenichro c/o Panasonic Corporation, Osaka 540-6207 (JP)
(74) Representative: TBK-Patent
(86) International application number: PCT/JP2008/003660
(87) International publication number: WO 2009/084155

(57) **Abstract**

A bonding material containing 2 to 10.5% by weight of Cu, 0.02 to 0.2% by weight of Ge and 89.3 to 97.98% by weight of Bi has heat resistance of up to 275°C and superior wettability, and a bonding material containing 2 to 10.5% by weight of Cu, 0.02 to 0.2% by weight of Ge, 0.02 to 0.11% by weight of Ni and 89.19 to 97.96% by weight of Bi has more superior heat resistance.

## Description

### Technical Field

The present invention relates to bonding materials (solder materials) containing no lead, as well as electronic components and bonded structures using such a bonding material, particularly to a bonding material for connecting an electronic element and an electrode that make up an electronic component, and more particularly to a bonding material which does not melt due to heating for bonding an electronic component to a board.

### Background Art

While recent years have seen growing interest in global environmental protection, there are concerns about lead melting from waste containing solder materials into soil. Accordingly, to address environmental issues, "lead-free" solder materials containing no lead have been developed, and in particular, high heat-resistant lead-free solder materials are attracting attention.

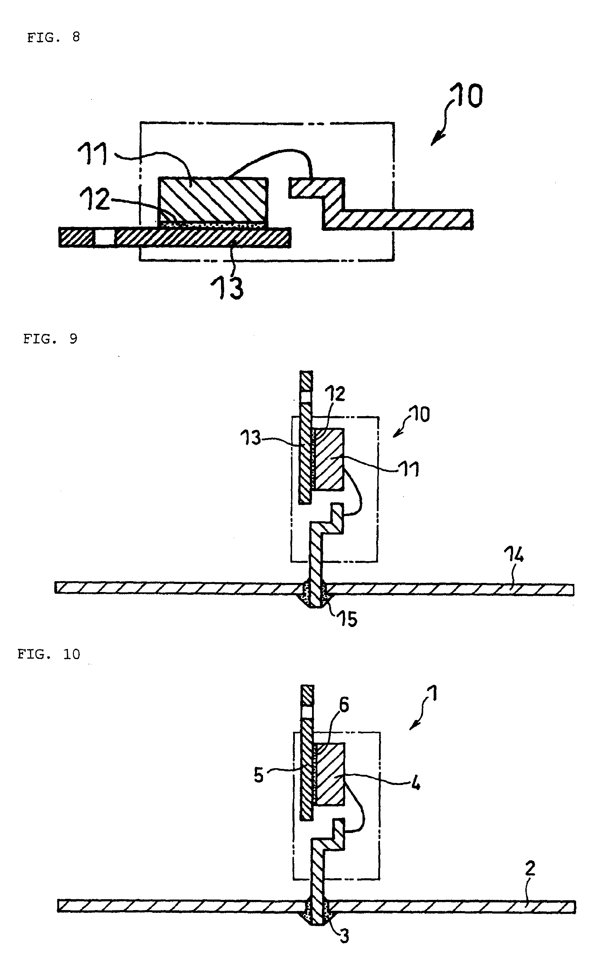

A typical application using the high heat-resistant lead-free solder material is intemal bonding of an electronic component such as a power transistor. As shown in FIG. 10, an electronic component 1 includes an electronic element 4, an electrode 5, and a bonding material 6 for bonding them. The electronic component 1 is bonded to a board 2 via another bonding material 3. As the other bonding material 3, a solder material having a melting point of from 220 to 230°C is generally used. For example, 96.5 wt% Sn-3 wt% Ag-0.5 wt% Cu (melting point: about 220°C) or 99.3 wt% Sn-0.7 wt% Cu (melting point: about 227°C) is used.

Soldering of the electronic component 1 and the board 2 is performed by a flow soldering machine. A solder material heated to 250°C or higher to melt is supplied to a portion to be bonded. At this time, the temperature of the electronic component 1 reaches 250 to 265°C. On this occasion, if the bonding material 6 bonding the electronic element 4 and the electrode 5 within the electronic component 1 melts, a final product might be defective. Therefore, the bonding material 6 to be used within the electronic component 1 is required to have a higher melting temperature than the maximum temperature of the electronic component 1 that is reached when soldering the electronic component 1 to the board 2.

Therefore, as a high heat-resistant solder material having a melting temperature of from 270 to 272°C, there has been proposed a solder material containing Bi as a main component and also containing 0.2 to 0.8% by weight of Cu and 0.02 to 0.2% by weight of Ge (see Patent Document 1).
Patent Document 1: Japanese Patent Publication No. 3886144 (FIG 2)

### Disclosure of the Invention

### Problem To be Solved by the Invention

However, the solder material of Patent Document 1 has a composition dose to a eutectic composition of Bi and Cu. When 99.5 wt% Bi-0.5 wt% Cu, which is a eutectic alloy of Bi and Cu, is produced, in some cases, the solder material might melt at 270°C. The solder material is suitable for bonding an electronic component to a board via reflow soldering, but in the case where a flow soldering machine is used, the electronic component might be heated to approximately 265°C, resulting in broken intemal bonding of the electronic component. Therefore, there is a difficulty in using the solder material of Patent Document 1 as a bonding material for internal bonding of the electronic component.

Also, an electronic component, such as a power transistor, in which high current flows, is required to have a heat resistance temperature approximately 10°C higher than the upper limit temperature during heating in view of safety assurance. Given that the electronic component might be heated to approximately 265°C, the bonding material to be used for intemal bonding of the electronic component is required to have heat resistance of 275°C or higher. Therefore, in some cases, even a high heat-resistant solder material having a melting temperature of from 270 to 272°C could not be used for internal bonding of the electronic component.

### Means for Solving the Problem

In view of the foregoing, the present invention aims to provide a bonding material having heat resistance of 275°C or higher and also provide a high-quality electronic component and bonded structure.
Specifically, the present invention is directed to a bonding material (bonding material A) containing 2 to 10.5% by weight of Cu, 0.02 to 0.2% by weight of Ge, and 89.3 to 97.98% by weight of Bi. Note that bonding material A may contain inevitable impurities.

The present invention is also directed to a bonding material (bonding material B) containing 2 to 10.5% by weight of Cu, 0.02 to 0.2% by weight of Ge, 0.02 to 0.11% by weight of Ni, and 89.19 to 97.96% by weight of Bi. Note that bonding material B may contain inevitable impurities.

The present invention is also directed to an electronic component induding an electronic element, an electrode connected to the electronic element, and the aforementioned bonding material A or B for bonding the electronic element and the electrode.

The present invention is further directed to a bonded structure induding an electronic component, a board having the electronic component mounted thereon, and a first bonding material for bonding the electronic component and the board, in which the first bonding material is a solder material having a melting point (solid phase temperature) of 230°C or lower, the electronic component includes an electronic element, an electrode connected to the electronic element, and a second bonding material for bonding the electronic element and the electrode, and the second bonding material is the aforementioned bonding material A or B.

Note that *x* wt% Bi-*y* wt% Cu-*z* wt% Ge-*w* wt% Ni is intended to mean an alloy containing *x*% by weight of Bi, *y*% by weight of Cu, *z*% by weight of Ge, and w% by weight of Ni. Also, Bi-*y* wt% Cu is intended to mean an alloy which contains *y*% by weight of Cu and the rest of which are Bi and Ge (orAl, U or P). Furthermore, Bi-y wt% Cu-*z* wt% Ge is intended to mean an alloy which contains *y*% by weight of Cu and *z*% by weight of Ge and the rest of which are Bi and Ni. Other alloys are also represented in a manner as described above.

### Effect of the Invention

According to the present invention, it is possible to provide a bonding material having a melting temperature of 275°C or higher and containing no lead. When the bonding material of the present invention is used for internal bonding of an electronic component such as a power transistor, the bonding material used for internal bonding does not melt due to heating for bonding the electronic component to a board. Thus, it is possible to suppress defects in the electronic component and a bonded structure induding the same.

### Brief Description of the Drawings

FIG 1 is a table showing eutectic point temperatures of binary alloys.
FIG 2 is a graph showing the DSC curve of 98 wt% Bi-2.0 wt% Cu.
FIG 3 is a graph showing the relationship between the heat absorption rate and the bonding strength of 98 wt% Bi-2.0 wt% Cu.
FIG 4 is a graph showing the relationship between the Cu content in bonding materials and the temperature at which the heat absorption rate reaches 20%.
FIG 5 is a graph showing the relationship between traces of elements contained in the bonding material and the amount of oxide production.
FIG 6 is a graph showing the relationship between the Ge content in Bi-2.0 wt% Cu and the amount of oxide production.
FIG 7 is a graph showing the relationship between the Ni content in Bi-7.4 wt% Cu-0.04 wt% Ge and the crystal circumference value.
FIG 8 is a schematic cross-sedional view illustrating the structure of an exemplary electronic component.
FIG 9 is a schematic cross-sectional view illustrating the structure of an exemplary bonded structure.
FIG 10 is a schematic cross-sectional view illustrating the structure of an exemplary conventional power transistor.

### Best Mode for Carrying Out the Invention

### Embodiment 1

The bonding material of the present embodiment contains 2 to 10.5% by weight of Cu, 0.02 to 0.2% by weight of Ge, and 89.3 to 97.98% by weight of Bi. The Cu content is preferably 2 to 6% by weight, and the Ge content is preferably 0.05 to 0.1 % by weight.

The bonding material of the present embodiment has heat resistance of up to 275°C, and therefore is suitable as, for example, a bonding material for bonding an electronic element and an electrode within an electronic component such as a power transistor. High heat resistance of the bonding material used in the electronic component suppresses defects in the electronic component that might be caused when bonding the electronic component to a board using a flow soldering machine. Also, the bonding material of the present embodiment contains no lead, which makes it possible to provide lead-free electric or electronic equipment.

To ensure heat resistance of up to 275°C, it is effective to use a binary alloy (an alloy composed of two kinds of elements) having a eutectic point temperature dose to 275°C as a base (matrix). When selecting a combination of elements having a eutectic point temperature dose to 275°C from among a number of elements, importance should be placed on whether the elements are toxic or not. Elements such as Hg, Sb, and Se are excluded based on the viewpoint of toxicity

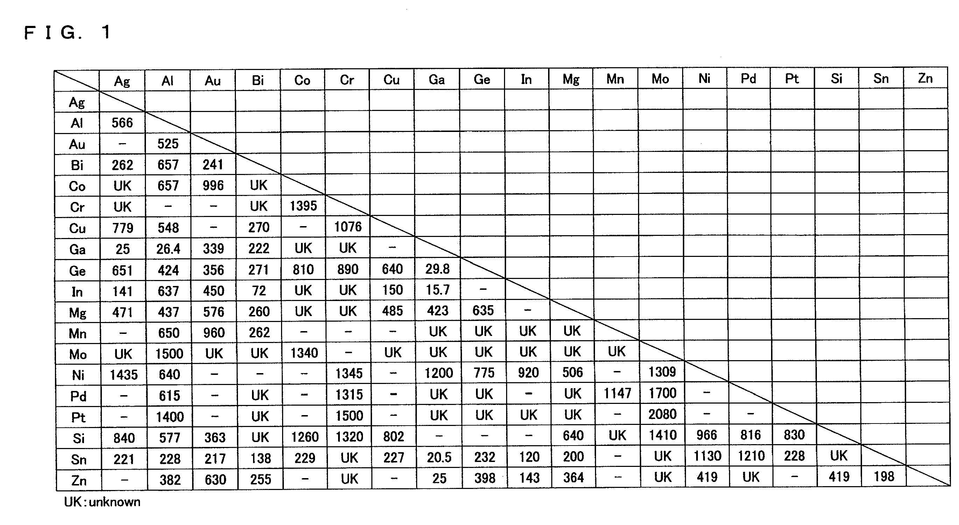

FIG 1 is a table showing eutectic point temperatures of binary alloys. A numerical value at the intersection of an element on the vertical axis and another element on the horizontal axis indicates the eutectic point temperature of the two kinds of elements. From FIG.1, it can be appreciated that, for example, the eutectic point temperature of an Sn-Ag alloy is 221 °C and an Ni-Cu alloy has no eutectic point. Based on FIG 1, combinations of elements having a eutectic point temperature dose to 275°C are narrowed down to two combinations: Bi and Cu; and Bi and Ge.

Here, the eutectic alloy of Bi and Cu contains 99.5% by weight of Bi and 0.5% by weight of Cu (99.5 wt% Bi-0.5 wt% Cu). Also, the eutectic alloy of Bi and Ge contains 99% by weight of Bi and 1% by weight of Ge (99 wt% Bi-1 wt% Ge). However, the price of Ge is about 420 times higher than that of Cu. Therefore, from the viewpoint of providing a low-cost material, it is advantageous to select 99.5 wt% Bi-0.5 wt% Cu containing 0.5% by weight of Cu, rather than an alloy containing 1 % by weight of Ge, as a base.

First, binary alloys of Bi and Cu with a Cu content of 0.5% by weight, 2.0% by weight, 5.0% by weight, 7.4% by weight, or 10.5% by weight were synthesized and examined for their behaviors during heating.

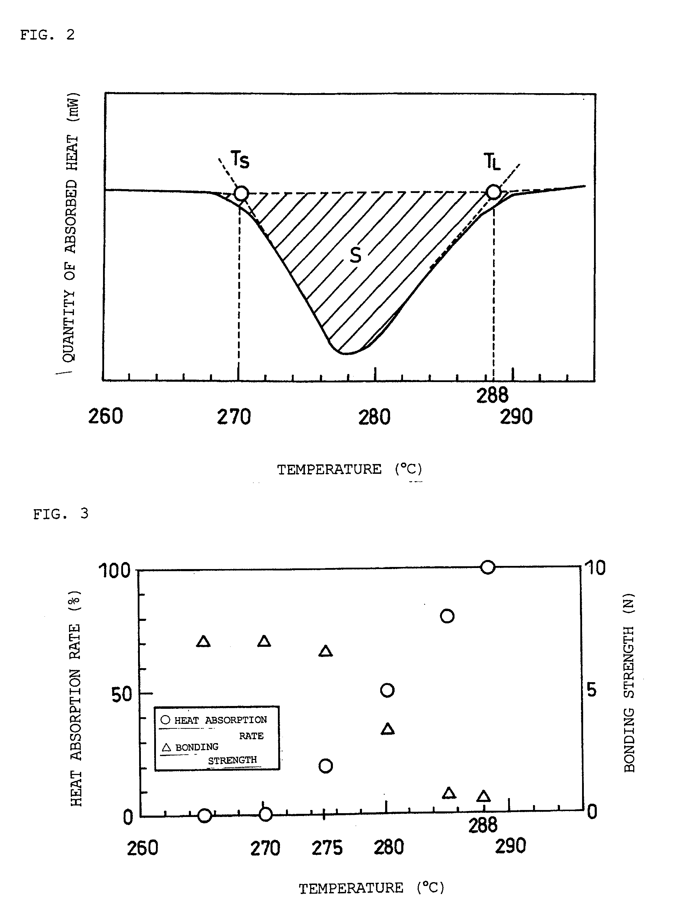

By way of example, FIG 2 illustrates the behavior of 98 wt% Bi-2 wt% Cu during heating, as measured by thermal analysis equipment. In the DSC (Differential Scanning Calorimetry) curve of FIG 2, the solid-phase temperature (T_{S}) indicates 270°C and the liquid phase temperature (T_{L}) indicates about 288°C. 98 wt% Bi-2.0 wt% Cu starts partly melting at 270°C, and completely melts into liquid state when it reaches around 288°C. The quantity of heat required for complete melting of the bonding material (hereinafter, referred to as total heat quantity Q) can be obtained from the heat absorption area (S). In the case of 98 wt% Bi-2.0 wt% Cu, the total heat quantity Q is 41.8 J/g.

Next, 98 wt% Bi-2.0 wt% Cu was examined regarding the relationship between the heat absorption rate and the bonding strength since the bonding material is required to have a sufficient bonding strength. The results are shown in FIG 3. The heat absorption rate is the percentage (%) of an integrated value for the quantity of heat absorbed up to a certain temperature relative to the total heat quantity Q.

The bonding strength was measured using a bonding tester. Specifically, a 1005-size capacitor was bonded to a copper electrode by a bonding material, and thereafter the bonded portion was heated to a predetermined temperature. At that temperature, the capacitor was pushed horizontally from one end surface at a moving speed of 1.0 × 10⁻⁴ m/s, thereby breaking the bonded portion. The same operation was repeated ten times, the strength at the time of the breakage of the bonded portion was measured up to 10 points, and an average value for the measured strengths was obtained.

In general, the bonding material has a higher bonding strength when it is in solid state than in liquid state. Also, the change of state of the bonding material is closely related to the heat absorption behavior. Accordingly, by examining the relationship between the heat absorption rate and the bonding strength, findings on the change of state of the bonding material can be obtained.

As can be seen from FIG 3, the heat absorption rate indicated by circles starts rising from the solid phase temperature of 270°C, and reaches 100% at the liquid phase temperature of 288°C. On the other hand, it can be appreciated that the bonding strength indicated by triangles is in the range from 6.7 to 7.1 N until 275°C which is above the solid phase temperature but the bonding strength abruptly decreases and deteriorates after exceeding 275°C and before reaching 280°C. The heat absorption rate at 275°C is 20%, and therefore it can be appreciated that the bonding strength is stable if the temperature range is such that the heat absorption rate is 20% or less. Note that the bonding strength here was determined to be sufficient if it is 6.7 N or higher. 275°C lies within the solid-liquid coexisting zone between the solid phase temperature and the liquid phase temperature. The bonding material starts melting at 270°C, whereas the bonding strength does not abruptly decrease until 275°C. This is because some solid portion remains between the solid phase temperature and the liquid phase temperature and the ratio of liquid gradually increases as the temperature rises.

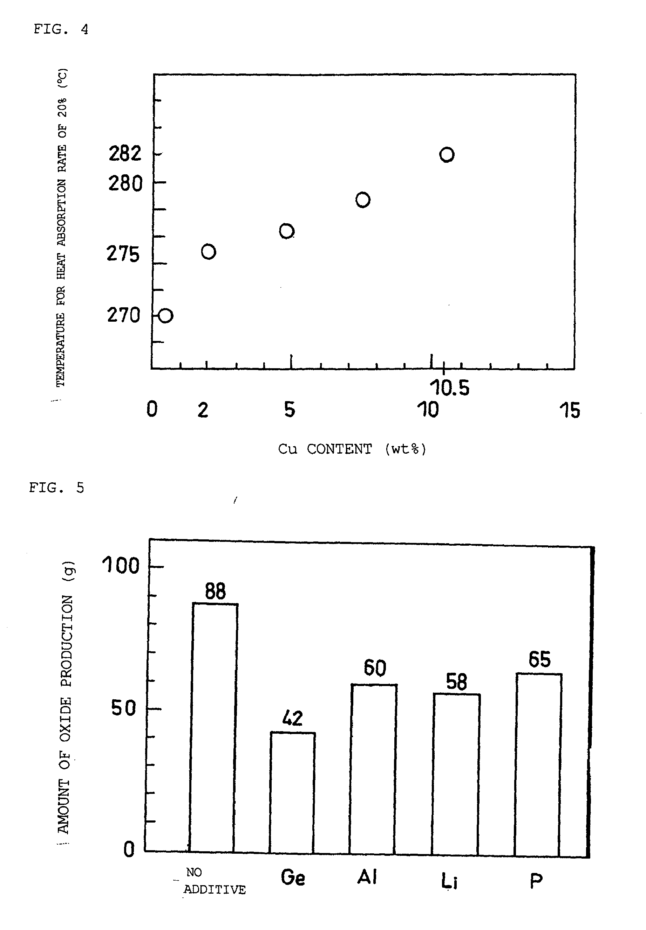

Accordingly, an examination was conducted as to the relationship between the temperature at which the heat absorption rate for ensuring a required bonding strength is 20% and the composition of the bonding material. FIG. 4 illustrates the relationship between the temperature for the heat absorption rate of 20% and the Cu content for binary alloys containing Bi and Cu. As can be seen from FIG 4, high heat-resistant bonding materials in which the temperature for the heat absorption rate of 20% is 275°C or higher have a Cu content of 2% by weight or more. Note that when the Cu content is 2% by weight, the temperature for the heat absorption rate of 20% is 275.2°C. It can be appreciated that the temperature for the heat absorption rate of 20% rises as the Cu content increases. When the Cu content exceeds 10.5% by weight, the temperature for the heat absorption rate of 20% is 282°C.

Note that, at the time of production of an electronic component such as a power transistor, the bonding material is used in melted form after heating it to 380°C. The heat absorption rate of the bonding material with a Cu content of 10.5% by weight is 97% at 380°C. If the Cu content is higher than this, melting at 380°C is insufficient, so that electronic component productivity is reduced. Therefore, the Cu content is desirably 10.5% by weight or less.

From the above, it can be appreciated that 98 wt% Bi-2.0 wt% Cu is a superior material capable of ensuring heat resistance of up to 275°C. However, tests on 98 wt% Bi-2.0 wt% Cu using the meniscus method revealed insufficient wettability. Experiments were repeatedly carried out to seek the cause of insufficient wettability, revealing that the high amount of Bi, which is 98.0% by weight, leads to an increased amount of oxide production, resulting in reduced wettability.

Oxidation of Bi can be suppressed by adding an element which is preferentially oxidized over Bi to the bonding material. Examples of the element which is preferentially oxidized over Bi include Ge, Al, U, and P.

FIG 5 illustrates the relationship between traces of elements contained in the bonding material and the amount of oxide production. The amount of oxide production was measured after adding 0.05% by weight of Ge, Al, Li or P to Bi-2.0 wt% Cu and stirring it at 300°C for 4 hours. When the weight of the entire sample is 10kg, the amount of oxide production is 88 g in the bonding material containing no additional element while it is 42 g in the bonding material containing Ge. This is presumably because Ge is preferentially oxidized on the surface of Bi-2.0 wt% Cu to form an oxide film, so that oxidation of Bi-2.0 wt% Cu is suppressed. From this result, it is appreciated that addition of Ge is suitable for suppressing oxidation of Bi-2.0 wt% Cu.

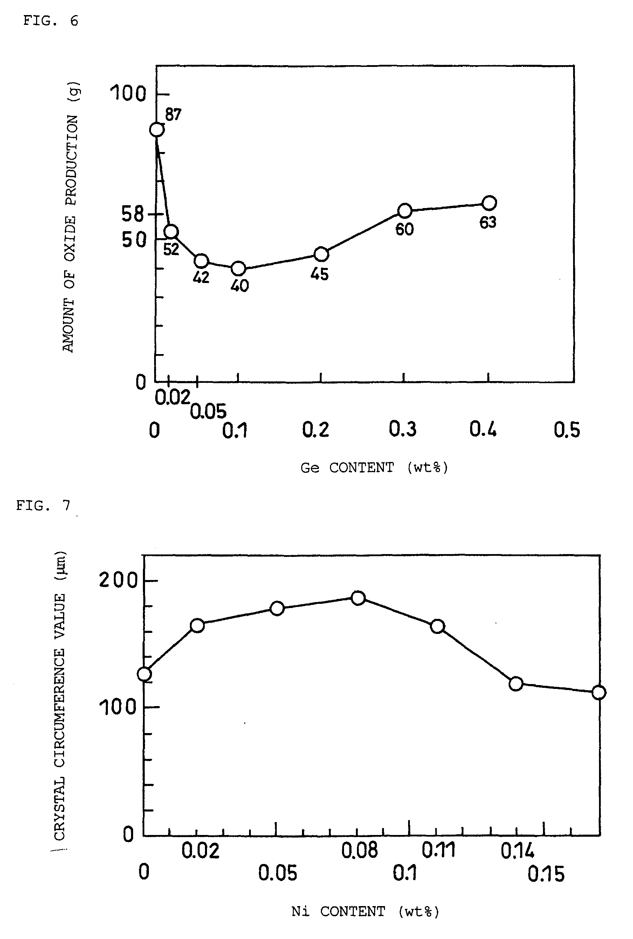

FIG. 6 illustrates the relationship between the Ge content in Bi-2.0 wt% Cu and the amount of oxide production. The amount of Bi decreases or increases as the amount of Ge increases or decreases. When Bi-2.0 wt% Cu contains 0.05% by weight of Li, the amount of oxide production is 58 g. In the case of a lower amount of oxide production, a sufficient effect is conceivably achieved to suppress oxide production. When the Ge content is 0.02% by weight, the amount of oxide production is 52 g, at which the effect starts becoming apparent. In the cases where the Ge content is 0.05% by weight, 0.1% by weight, and 0.2% by weight, oxide production is respectively 42 g, 40 g, and 45 g, showing the effect. On the other hand, when the Ge content is 0.3% by weight, the amount of oxide production is 60 g, which is greater than the reference value of 58 g.

From the above, it can be appreciated that to decrease the amount of oxide production and thereby to enhance wettability, the Ge content needs to be in the range from 0.02% by weight to 0.2% by weight. However, the price of Ge is high and about 420 times the price of Cu, and therefore a small amount of Ge is desirably used. Furthermore, when comparing the Ge contents of 0.05% by weight and 0.2% by weight, the difference in the amount of oxide production is small therebetween. Thus, in view of educing the usage of high-priced Ge, it is also effective to keep the Ge content within the range from 0.02 to 0.05% by weight.

Table 1 illustrates exemplary compositions of the bonding material of the present embodiment. Also shown are temperature (heat resistance temperature) and wettability where the heat absorption rate of the bonding material is 20%.

**[Table 1]**

| | Bi (wt%) | Cu (wt%) | Ge (wt%) | Heat Resistance Temperature (°C) | Wettability |
|---|---|---|---|---|---|
| Example 1 | 97.98 | 2.0 | 0.02 | 275.1 | Satisfactory |
| Example 2 | 97.94 | 2.0 | 0.06 | 275.0 | Satisfactory |
| Example 3 | 96.44 | 3.5 | 0.06 | 275.8 | Satisfactory |
| Example 4 | 94.16 | 5.8 | 0.04 | 276.7 | Satisfactory |
| Example 5 | 91.5 | 8.4 | 0.10 | 280.4 | Satisfactory |
| Example 6 | 89.3 | 10.5 | 0.20 | 281.2 | Satisfactory |
| Comparative Example 1 | 89.5 | 10.5 | 0 | 281.4 | Insufficient |
| Comparative Example 2 | 89.1 | 10.5 | 0.4 | 281.1 | Insufficient |

Of six Examples 1 to 6, 89.3 wt% Bi-10.5 wt% Cu-0.2 wt% Ge of Example 6 has the highest heat resistance. However, when considering the balance between heat resistance and workability in the soldering process, 96.44 wt% Bi-3.5 wt% Cu-0.06 wt% Ge of Example 3 is a superior composition.

Shown as comparative examples are a bonding material containing no Ge (Comparative Example 1 ) and 89.1 I wt% Bi-10.5 wt% Cu-0.4 wt% Ge (Comparative Example 2). It is appreciated that both of them are far from having sufficient wettability, and are not suitable as bonding materials.

By using the bonding materials of Examples 1 to 6, electronic elements and electrodes were bonded to complete electronic components. Speafically,100 g of bonding material of Example 1 was added to a stainless steel container (40 mm dia., 90 mm deep), and heated to 380°C to melt. The stainless steel container had a 0.2 mm dia. discharge hole provided in the bottom. The stainless steel container had provided at its upper portion a pressure control mechanism for applying pressure to the inside of the container. Activation of the pressure control mechanism makes it possible to discharge a predetermined amount of molten material from the discharge hole in the bottom of the container. By using a unit consisting of the stainless steel container and the pressure control mechanism, 0.3 g of molten material was supplied onto a Cu lead frame, and then, an Si chip (3 mm × 4 mm) was mounted on the molten material. After cooling to room temperature, the lead frame and the Si chip were bonded by the bonding material.

An electrode terminal of the lead frame and an electrode terminal on the bonded Si chip were rendered conductive through Au wire connection. Thereafter, the entirety was molded with epoxy resin to complete an electronic component (TO-220F).

A lead terminal of the electronic component (TO-220F) thus completed was inserted into a paper phenol circuit board, and soldered using molten 96.5 wt% Sn-3 wt% Ag-0.5 wt% Cu or 99.3 wt% Sn-0.7 wt% Cu as a bonding material. For the bonding materials of Examples 2 to 6 also, similar procedures were taken for test production. Thereafter, an inspection process confirmed that the boards bonded with the electronic components were not defective and were equivalent in performance to boards bonded with electronic components completed using typical lead-containing solder.

From the above, it is understood that, when the bonding material contains 2 to 10.5% by weight of Cu, 0.02 to 0.2% by weight of Ge, and 89.3 to 97.98% by weight of Bi, heat resistance of up to 275°C can be ensured, and such a material is suitable for intemal bonding of electronic components such as power transistors. Thus, when the bonding material of the present embodiment is used for intemal bonding of an electronic element and an electrode, an internally bonded portion does not melt due to heating for bonding the electronic component to a board, resulting in no defects.

### Embodiment 2

The bonding material of the present embodiment contains 2 to 10.5% by weight of Cu, 0.02 to 0.2% by weight of Ge, 0.02 to 0.11 % by weight of Ni, and 89.19 to 97.96% by weight of Bi. The Cu content is preferably 2 to 6% by weight, the Ge content is preferably 0.05 to 0.1 % by weight, and the Ni content is preferably 0.05 to 0.08% by weight.
The bonding material of the present embodiment has higher impact resistance than the bonding material of Embodiment 1.

The impact resistance can be evaluated by a test in which a 60 g weight is dropped from the height of 180 mm to hit a side surface of a chip capacitor of a 1.6 mm × 0.8 mm size.

A chip capacitor having a portion bonded with 92.56 wt% Bi-7.4 wt% Cu-0.04 wt% Ge was subjected to the aforementioned impact resistance test, and broken at the bonded portion. Cross-sectional observation of the broken bonded portion found that the breakage occurred at the interface between α phase abundant in Bi content and β phase abundant in Cu content.

Here, homogeneity between α and β phases can be evaluated by crystal circumference values. The crystal circumference value is defined as a total circumferential length of α phases present within the range of 10 µm × 10 µm. When the crystal circumference value is high, α and β phases are mixed sufficiently, and when the crystal circumference value is low, a and β phases are mixed insufficiently.
The crystal circumference value was measured at the cross section of the bond broken by the test and it was 126 µm.

To increase the crystal circumference value, it is effective to add a core element for phase formation when solidifying the bonding material. Suitable as such an element is Ni, which does not melt at the melting temperature of the bonding material and is nontoxic and superior in terms of cost.

FIG 7 illustrates the relationship between the Ni content in Bi-7.4 wt% Cu-0.04 wt% Ge and the crystal circumference value. The amount of Bi decreases or increases as the amount of Ni increases or decreases. The crystal circumference value of a bonding material containing 0.02% by weight of Ni is 165 µm, which is higher than in the case where no Ni is contained. In the cases where the Ni content is 0.05% by weight, 0.08% by weight, and 0.11% by weight also, the crystal circumference value is higher compared to the case where no Ni is contained, resulting in enhanced mixing of α and β phases. On the other hand, when the Ni content is 0.14% by weight, the crystal circumference value falls to 118 µm, which is approximately equivalent to that in the case where no Ni is contained.

The above suggests that to achieve enhanced impact resistance when compared to the case where no Ni is contained, the Ni content is required to be set within the range from 0.02% by weight to 0.11 % by weight. Also, when the Ni content exceeds 0.08% by weight, the crystal circumference value starts falling, and therefore the Ni content is desirably set within the range from 0.02% by weight to 0.08% by weight.

Table 2 illustrates exemplary compositions of the bonding material of the present embodiment. Also shown are temperature (heat resistance temperature) and impact resistance where the heat absorption rate of the bonding material is 20%.

**[Table 2]**

| | Bi (wt%) | Cu (wt%) | Ge (wt%) | Ni (wt%) | Heat Resistance Temperature (°C) | Impact Resistance |
|---|---|---|---|---|---|---|
| Example 7 | 97.96 | 2.0 | 0.02 | 0.02 | 275.2 | Satisfactory |
| Example 8 | 97.9 | 2.0 | 0.06 | 0.04 | 275.2 | Satisfactory |
| Example 9 | 96.4 | 3.5 | 0.06 | 0.04 | 275.7 | Satisfactory |
| Example 10 | 94.06 | 5.8 | 0.04 | 0.10 | 276.7 | Satisfactory |
| Example 11 | 91.4 | 8.4 | 0.10 | 0.10 | 280.3 | Satisfactory |
| Example 12 | 89.19 | 10.5 | 0.20 | 0.11 | 281.5 | Satisfactory |
| Example 13 | 89.3 | 10.5 | 0.20 | 0 | 281.2 | Insufficient |
| Example 14 | 89.13 | 10.5 | 0.20 | 0.17 | 281.8 | Insufficient |

Of six Examples 7 to 12, 89.19 wt% Bi-10.5 wt% Cu-0.20 wt% Ge-0.11 wt% Ni of Example 12 has the highest heat resistance. However, when considering the balance between heat resistance and workability in the soldering process, 96.4 wt% Bi-3.5 wt% Cu-0.06 wt% Ge-0.04 wt% Ni of Example 9 is a superior composition. Also, all the bonding materials of Examples 7 to 12 have compositions superior in impact resistance compared to those of Examples 1 to 6.

Table 2 also illustrates a bonding material (Example 13) containing no Ni and 89.13 wt% Bi-10.5 wt% Cu-0.2 wt% Ge-0.17 wt% Ni containing excess Ni (Example 14). Both of them are superior in heat resistance and wettability, but it can be appreciate that no effect of enhancing impact resistance can be achieved.

The bonding materials of Examples 7 to 12 were used to bond electronic elements and electrodes, thereby completing electronic components, as in Embodiment 1. Then, the electronic components were mounted on boards and introduced into a flow soldering machine for soldering with molten 96.5 wt% Sn-3 wt% Ag-0.5 wt% Cu or 99.3 wt% Sn-0.7 wt% Cu as a bonding material, as in Embodiment 1. Thereafter, an inspection process confirmed that the boards bonded with the electronic components were not defective, and were equivalent in performance to boards bonded with electronic components completed using typical lead-containing solder.

From the above, it can be appreciated that when the bonding material contains 2 to 10.5% by weight of Cu, 0.02 to 0.2% by weight of Ge, 0.02 to 0.11% by weight of Ni, and 89.19 to 97.96% by weight of Bi, heat resistance of up to 275°C can be ensured, and also impact resistance is enhanced, indicating that such a bonding material is suitable for intemal bonding of electronic components such as power transistors. Thus, when the bonding material of the present embodiment is used for internal bonding of an electronic element and an electrode, an internally bonded portion does not melt due to heating for bonding the electronic component to a board, and also does not fail due to impact.

### Embodiment 3

The electronic component of the present embodiment includes an electronic element, an electrode connected to the electronic element, and a bonding material for bonding the electronic element and the electrode. Here, as the above bonding material, the bonding material of Embodiment 1 or 2 can be used.

The electronic element is formed by, but not specifically limited to, for example, an Si chip, an SiC chip, or a coil. The electronic component is not limited to a power transistor, and examples thereof include a chip component, surface-mounted components, such as QFP (Quad Flat Package) and BGA (Ball Grid Array), and insertion components, such as axial components and radial components.

FIG 8 is a schematic cross-sectional view illustrating the structure of a power transistor as an example of the electronic component of the present embodiment. The power transistor 10 is a semiconductor mounting component which is loaded with high voltage or current to generate intense heat. An electronic element 11 is bonded to an electrode 13 by a bonding material 12. The power transistor 10 is mounted onto a predetermined board using a flow soldering machine in another process, thereby forming electric or electronic equipment. Even when the temperature of the power transistor reaches 265°C at the time of mounting onto the board, the bonding material of Embodiment 1 or 2 does not melt. Thus, the bond between the electronic element 11 and the electrode 13 is not broken.

### Embodiment 4

The bonded structure of the present embodiment includes an electronic component, a board having the electronic component mounted thereon, and a first bonding material for bonding the electronic component and the board, in which the first bonding material has a melting point (solid phase temperature) of 230°C or lower, the electronic component includes an electronic element, an electrode connected to the electronic element, and a second bonding material for bonding the electronic element and the electrode, and the second bonding material is a bonding material as described in Embodiment 1 or 2.

FIG 9 is a schematic cross-sedional view of an example of the bonded structure of the present embodiment, which includes the power transistor 10 of Embodiment 3 and a board 14 having the same mounted thereon. Used for bonding the power transistor 10 and the board 14 is a first bonding material 15 having a melting point of 230°C or lower. Used as the first bonding material is, for example, 96.5 wt% Sn-3 wt% Ag-0.5 wt% Cu or 99.3 wt% Sn-0.7 wt% Cu.

### Industrial Applicability

The bonding material of the present invention can be preferably used in, for example, an electronic component to be mounted on a board by a flow soldering machine, and also in a bonded structure induding the same. The bonding material of the present invention is particularly suitable for electronic components for which heat resistance of up to 275°C is required and is also applicable to electronic components for which high impact resistance is required.

## Claims

1. A bonding material containing 2 to 10.5% by weight of Cu, 0.02 to 0.2% by weight of Ge, and 89.3 to 97.98% by weight of Bi.

2. A bonding material containing 2 to 10.5% by weight of Cu, 0.02 to 0.2% by weight of Ge, 0.02 to 0.11 % by weight of Ni, and 89.19 to 97.96% by weight of Bi.

3. An electronic component comprising an electronic element, an electrode connected to the electronic element, and a bonding material of claim 1 or 2 for bonding the electronic element and the electrode.

4. A bonded structure comprising an electronic component, a board having the electronic component mounted thereon, and a first bonding material for bonding the electronic component and the board, the first bonding material having a melting point of 230°C or lower,
wherein the electronic component includes an electronic element, an electrode connected to the electronic element, and a second bonding material for bonding the electronic element and the electrode, the second bonding material being a bonding material of claim 1 or 2.
